# EUROPÄISCHE PATENTSCHRIFT

(11) **EP 1 535 819 B1**
(45) Veröffentlichungstag und Bekanntmachung des Hinweises auf die Patenterteilung: **07.06.2006**
(21) Anmeldenummer: 04078116.3
(22) Anmeldetag: 11.11.2004
(51) Int. Cl.: B61L 5/18

(54) **Einheit zum sicheren Messen oder Erkennen eines elektrischen Stroms einer sicherungstechnischen Einrichtung**
Device for secure measurements and detection of an electric current for a safety device
Dispositif pour mesurer et détecter des courants électriques dans un dispositif de sécurité

(30) Priorität: 25.11.2003 DE 10355861
(43) Veröffentlichungstag der Anmeldung: 01.06.2005
(73) Patentinhaber: SIEMENS AKTIENGESELLSCHAFT, 80333 München (DE)
(72) Erfinder: Priebe, Alexander, 38108 Braunschweig (DE); Temming, Rudolf, 38154 Königslutter (DE)

(56) Entgegenhaltungen:
- DE-A1- 3 140 559
- US-A- 3 710 364
- US-A- 5 041 817

## Beschreibung

Die Erfindung betrifft eine Einheit zum sicheren Messen oder Erkennen eines elektrischen Stroms einer sicherungstechnischen Einrichtung gemäß dem Oberbegriff des Anspruchs 1.

Strommessanordnungen zum signaltechnisch sicheren Messen eines elektrischen Stroms sind bekannt, wobei der zu messende Strom ein Wechselstrom als auch ein Gleichstrom sein kann. Gemäß den geltenden Vorschriften muss die Messung beim signaltechnisch sicheren Messen mit einer galvanischen Potenzialtrennung >3 KV verfolgen.

Hierzu kann im Falle von Wechselstrom ein Stromübertrager verwendet werden, der eine vom zu messenden Strom durchflossene Primärspule aufweist. Der Stromübertrager trägt galvanisch von der Primärspule getrennt eine Sekundärspule, die wie ein Sensor in Abhängigkeit vom Magnetfeld der Primärspule ein Wechselspannungssignal abgibt. Das dabei zur Anwendung kommende Transformatorprinzip ist allerdings nur bei Wechselstrom nutzbar. Darüber hinaus weist ein Stromübertrager immer ein großes Volumen auf.

Weiter ist es bekannt, die aufgrund des zu messenden Stroms an einem Shunt-Widerstand abfallende Spannung mittels eines Optokopplers zu übertragen. Das dabei von einem ersten optische Element des Optokopplers erzeugte spannungsproportionale Lichtsignal wird im Koppler von einem zweiten optischen Element wieder in ein proportionales elektrisches Signal umgewandelt, beispielsweise in eine Spannung. Die optische Kopplung ermöglicht eine einfache galvanische Potenzialtrennung. Für die Strommessung mittels Optokoppler sind mehrere DC-DC-Wandlern erforderlich, die nachteiligerweise wiederum das Volumen und die Kosten der Strommessanordnung erhöhen, da ein relativ großer Schaltungsaufwand erforderlich ist.

Außerdem ist es bekannt, ein Relais in einer Sicherheitsbauform zu Erzielung der erforderlichen galvanischen Trennung zu verwenden. Das Relais wird in Reihe mit dem zu messenden Strom geschaltet und öffnet seine mechanischen Kontakte, wenn der Strom einen vorgegebenen Wert überschreitet. Auch diese Ausführung weist ein relativ großes Volumen bei hohen Kosten auf, wobei hinzukommt, dass die mechanischen Kontakte des Relais im Laufe der Zeit verschleißen. Das Relais dient bei der beschriebenen Betriebsweise als Stromfenster zum Erkennen eines elektrischen Stroms mit einem Mindeststromwert. Es ist auch möglich das Relais so auszubilden, dass es bei einem Maximalstromwert wieder abschaltet, also erkennt, ob sich der Strom in einem vorgegebenen Stromfenster befindet.

Die Aufgabe der Erfindung ist es, eine kleinvolumige Einheit zum sicheren Messen oder Erkennen eines elektrischen Strom anzugeben, die zusätzlich kostengünstig ist.

Die Lösung dieser Aufgabe ist durch die im Anspruch 1 angegebenen Merkmale gegeben. Die kennzeichnenden Merkmale der Unteransprüche enthalten vorteilhafte Ausgestaltungen.

Die Lösung sieht vor, dass die Einheit zum sicheren Messen oder Erkennen eines elektrischen Stroms zwei voneinander unabhängige Komponenten umfasst, dass im Bereich des Sensors eine Prüfspule angeordnet ist, durch die gesteuert von einer der beiden Komponenten zumindest ein in Stromwert und Stromrichtung vorgegebener Stromimpuls geschickt wird, wobei das vom Stromimpuls erzeugte Prüfmagnetfeld das Sensorsignal ändert, und dass das Funktionieren der Einheit von der anderen Komponente anhand der Änderung geprüft wird. Auf diese Weise kann die Messung einfach durchgeführt werden. Die Einheit funktioniert mit beiden Stromarten, Wechselstrom als auch Gleichstrom. Sie weist ein geringes Volumen auf und ist bei niedrigen Kosten herstellbar. Die Einheit ist verschleißfrei, da keine mechanischen Kontakte vorhanden sind. Mit geringem Aufwand ist eine hohe Potentialtrennung möglich.

Eine konstruktive einfache universelle Einheit weist einen sicheren Rechner mit zwei unabhängigen Kanälen als unabhängige Komponenten auf.

Bei einer einfachen Ausführung ist der Sensor durch die beiden hintereinander angeordneten zylindrischen Spulen hindurch gesteckt.

Eine ausreichende Empfindlichkeit ist gegeben, wenn der Sensor einen Hall-Sensor aufweist.

Die Einheit ist zur Prüfung einer potentialfreien Kontaktabfrage in der Anwendung "Erkennen eines elektrischen Stroms" einer sicherungstechnischen Einheit verwendbar, wenn die Primärspule eine Strombegrenzung aufweist.

Die Einsetzbarkeit der Einheit lässt sich erhöhen, wenn die Einheit als Modul ausgebildet ist,
dass das Modul zu einer Gruppe von miteinander kombinierbaren Funktions-Modulen gehört, deren Funktionalitäten jeweils unterschiedlichen Prozessanschaltungen für das sichere Betreiben von sicherungstechnischen Einrichtungen gemeinsam sind, und dass zumindest ein weiteres Funktions-Modul der sichere Rechner ist.

Die Erfindung wird nachfolgend anhand einer Zeichnung näher beschrieben. Es zeigen:
- Fig. 1: eine Einheit zum sicheren Messen oder Erkennen eines elektrischen Stroms,
- Fig. 2: Zeitdiagramme der Einheit gemäß Fig. 1 und
- Fig. 3: eine sichere Kontaktabfrageeinrichtung unter Verwendung der Einheit gemäß Fig. 1.

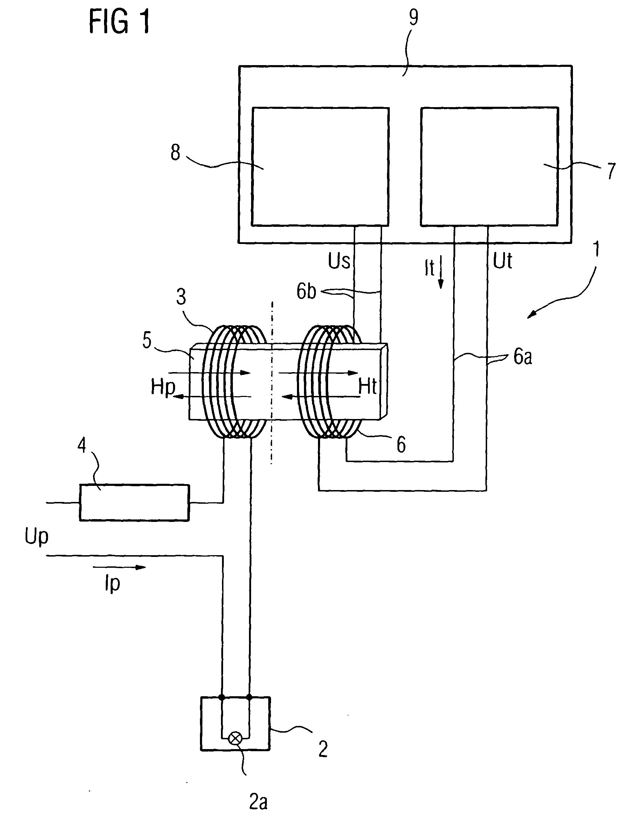

Fig. 1 zeigt eine Einheit 1 zum sicheren Messen oder Erkennen eines elektrischen Stroms, die zu einer nicht gezeigten Prozessanschaltung für das sichere Betreiben einer sicherungstechnischen Einrichtung gehören, also beispielsweise für die Ansteuerung von Signallampen, Weichenabtrieben, Achszählern, Freimeldereinrichtungen, Geschwindigkeitsmesseinrichtungen und Fahrsperren als auch für sichere Kontaktabfragen.

Die Einheit 1 ist an einen Verbraucher 2 in Form einer Signallampe 2a angeschlossen, durch die ein Strom Ip in der gezeigten Pfeilrichtung durch den Verbraucher 2 fließt. Der Verbraucher 2 ist mit einer Primärspule 3 in Reihe geschaltet. Der Verbraucher 2, die Primärspule 3 und ein Schalter 4 bilden den Primärstromkreis. Am Primärstromkreis liegt eine Spannung Up an bzw. fällt die Spannung Up ab. Die Primärspule 3 ist in Fig. 1 als zylindrische Spule mit einer zentralen Durchgangsöffnung gezeigt, durch die ein Sensor 5 hindurchverläuft, der die Magnetfeldstärke Hp der Primärspule 3 in ein Spannungssignal (Spannung Us) umwandelt. Im Sensor 5 befindet sich ein nichtgezeigter Hall-Sensor, welcher die Umwandlung vornimmt. Neben der Primärspule 3 befindet sich eine weitere zylindrische Spule, eine Prüfspule 6, wobei beide Spulen 3, 6 hintereinander angeordnet sind. Der Sensor 5 verläuft gemäß Fig. 1 ebenfalls durch zentrale Öffnung dieser Spule 6 hindurch. Der Abstand der beiden Spulen 5, 6 ist so gewählt, dass eine ausreichende galvanische Trennung sichergestellt ist.

Der Sensor 5 und die Prüfspule 6 sind jeweils mit voneinander unabhängigen Komponenten 7, 8 eines sicheren Rechners 9 verbunden, wobei es sich bei den beiden Komponenten 7, 8 um zwei unabhängige Kanäle des Rechners 9 handelt.

Über die Verbindung 6a des Rechners 9 kann dieser Stromimpulse durch die Prüfspule 6 schicken, mit einem vorgegebenen Stromwert und einer vorgegebenen Stromrichtung. Diese Steuerung erfolgt durch die Komponente 7. Der Stromimpuls erzeugt mittels der Prüfspule 6 ein Prüfmagnetfeld Ht, wobei beide Spulen 5, 6 so dicht nebeneinander angeordnet sind, dass dieses Prüfmagnetfeld das Magnetfeld der Primärspule 3 entsprechend dem Stromimpuls (Stromwert, Stromrichtung) ändert. Dadurch kommt es zu einer Änderung des magnetabfeldabhängigen Spannungssignals (Spannung Us) des Sensors. Die Änderung wird von der anderen Komponente 8 des Rechners 9 erfasst (Verbindung 6b) und auf diese Weise das Funktionieren der Einheit geprüft.

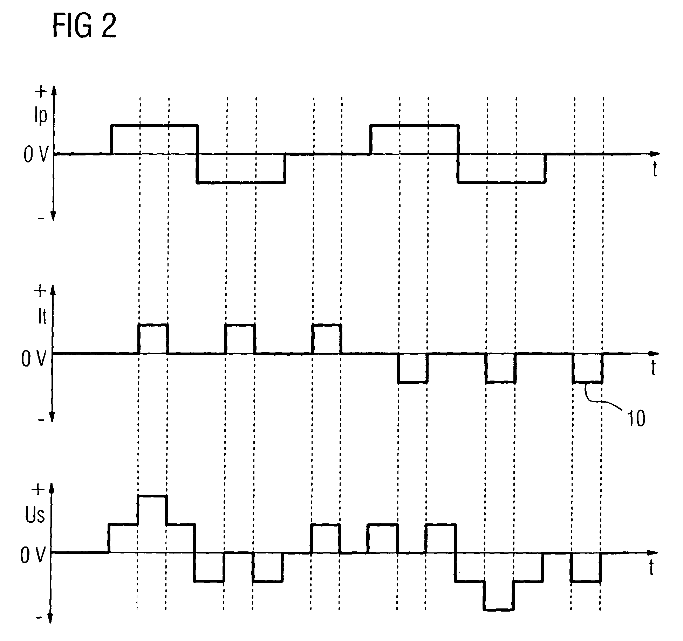

Die entsprechenden Zeitdiagramme sind in der Fig. 2 dargestellt. Das obere Diagramm zeigt einen digitalen Stromverlauf Ip als Funktion der Zeit t. Das mittlere Diagramm zeigt eine Folge von digitalen Prüfimpulsen, d.h. Stromimpulse It mit der Bezugsziffer 10 als Funktion der Zeit t. Das untere Diagramm stellt die Spannung Us (Sensorsignal) am Eingang der Komponente 8 bzw. dem Ausgang des Sensors 5 als Funktion der Zeit t dar. Dieses Diagramm lässt erkennen, dass bei einwandfreier Funktion der Einheit 1 die Stromimpulse 10 zu einer entsprechenden Erhöhung bzw. Verringerung der Spannung Us führt.

Im einfachsten Falle wird von der Komponenten 8 lediglich geprüft, ob es zu einer Änderung der Spannung Us in der entsprechenden Richtung kommt, woraus dann die korrekte Funktion der Einheit 1 abgeleitet wird.

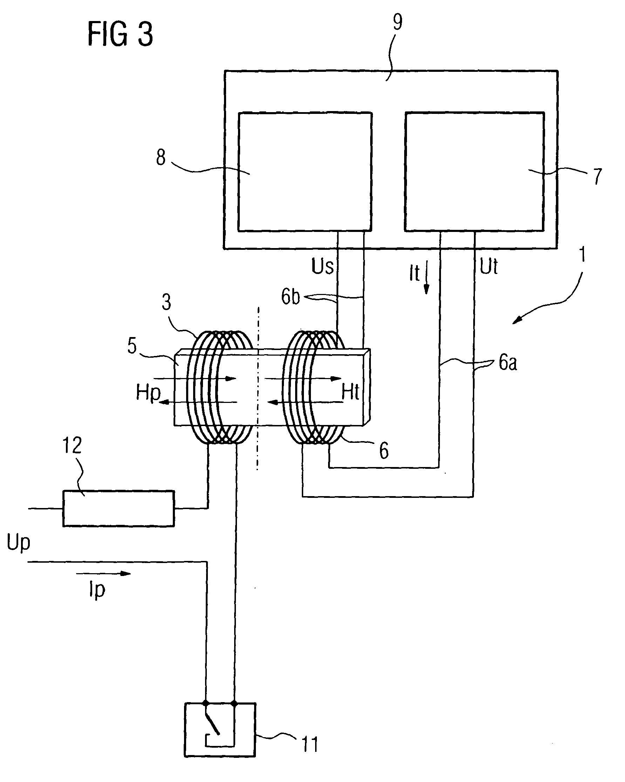

Fig. 3 stellt die Einheit im Zusammenhang mit einer Prüfung einer potentialfreien Kontaktabfrage einer sicherungstechnischen Einrichtung dar, wobei es lediglich auf das Erkennen eines elektrischen Stroms Ip ankommt. Im Unterschied zu Fig. 1 ist der Verbraucher 2 hier ein zu überwachender Kontakt 11, der in Fig. 3 in geöffnetem Zustand gezeigt ist. Die Funktionsweise der Einheit 1 ist analog zu der gemäß Fig. 1. Allerdings muss zum Schutz der Einheit eine Strombegrenzung 12 in den Primärstromkreis geschaltet sein.

## Patentansprüche

1. Einheit (1) zum sicheren Messen oder Erkennen eines elektrischen Stroms einer sicherungstechnischen Einrichtung (2a, 11), insbesondere einer Signallampe (2a), eines Weichenantriebs, eines Achszählers, einer Freimeldeeinrichtung und dergleichen sowie eine sichere Kontaktabfrageeinrichtung,
mit einer vom Strom durchflossenen Primärspule (3) zur Erzeugung eines Magnetfeldes (Hp), das von einem galvanisch von der Primärspule (2a) getrennten Sensor (5) in ein magnetfeldabhängiges Sensorsignal (Us) umgewandelt wird, und
mit einer Prüfspule (6), durch die gesteuert von einem Rechner (9) ein in Stromwert und Stromrichtung vorgegebener Strom geschickt wird, wobei das vom Strom erzeugte Prüfmagnetfeld (Ht) das Sensorsignal (Us) ändert und das Funktionieren der Einheit (1) anhand der Änderung des Sensorsignals (Us) geprüft wird,
**dadurch gekennzeichnet,**
**dass** der Rechner (9) sicherungstechnisch sicher zwei voneinander unabhängige Kanäle (7, 8) aufweist,
**dass** der Strom durch die Prüfspule (6) als Stromimpuls (10) von einem der beiden Kanäle (7 oder 8)geschickt wird und
**dass** das Funktionieren der Einheit (1) vom anderen Kanal (8 bzw. 7) anhand der Änderung geprüft wird.

2. Einheit (1) nach Anspruch 1,
**dadurch gekennzeichnet,**
**dass** der Sensor (5) durch die beiden hintereinander angeordneten zylindrischen Spulen (3, 6) hindurch gesteckt ist.

3. Einheit (1) nach Anspruch 1 oder 2,
**dadurch gekennzeichnet,**
**dass** der Sensor (5) einen Hall-Sensor aufweist.

4. Einheit (1) nach einem der Ansprüche 1 - 3,
**dadurch gekennzeichnet,**
**dass** die Einheit (1) zur Prüfung einer potentialfreien Kontaktabfrage in der Anwendung "Erkennen eines elektrischen Stroms einer sicherungstechnischen Einrichtung" verwendbar ist, wobei der Primärspule (3) eine Strombegrenzung (12) vorzuschalten ist.

5. Einheit (1) nach einem der Ansprüche 1 - 4,
**dadurch gekennzeichnet,**
**dass** die Einheit (1) als Modul ausgebildet ist,
**dass** das Modul zu einer Gruppe von miteinander kombinierbaren Funktions-Modulen gehört, deren Funktionalitäten jeweils unterschiedlichen Prozessanschaltungen für das sichere Betreiben von sicherungstechnischen Einrichtungen (2a, 11) gemeinsam sind, und dass zumindest ein weiteres Funktions-Modul der sichere Rechner (9) ist.

## Claims

1. Unit (1) for reliably measuring or detecting an electric current of a safety device (2a, 11), in particular a signal lamp (2a), a railway switch drive, an axle counter, a notification device or the like and a safe contact checking device, having a primary coil (3), through which the current flows, for inducing a magnetic field (Hp) which is converted to a sensor signal (Us) which is dependent on the magnetic field by a sensor (5), which is DC-isolated from the primary coil (2a), and having a test coil (6), through which a current predetermined in terms of its current value and current direction is sent, controlled by a computer (9), in which case the test magnetic field (Ht) induced by the current changes the sensor signal (Us), and the functioning of the unit (1) is tested using the change in the sensor signal (Us), **characterized in that** the computer (9) for safety reasons reliably has two mutually independent channels (7, 8), **in that** the current is sent through the test coil (6) as a current pulse (10) from one of the two channels (7 or 8), and **in that** the functioning of the unit (1) is tested by the other channel (8 or 7) using the change.

2. Unit (1) according to Claim 1, **characterized in that** the sensor (5) is pushed through the two cylindrical coils (3, 6) which are arranged one behind the other.

3. Unit (1) according to Claim 1 or 2, **characterized in that** the sensor (5) has a Hall sensor.

4. Unit (1) according to one of Claims 1 - 3, **characterized in that** the unit (1) can be used for testing a floating contact check in the application "detection of an electric current of a safety device", in which case a current-limiting device (12) needs to be connected upstream of the primary coil (3).

5. Unit (1) according to one of Claims 1 - 4, **characterized in that** the unit (1) is in the form of a module, **in that** the module belongs to a group of functional modules which can be combined with one another and whose functionalities are each common to different process interface connections for safe operation of safety devices (2a, 11), and **in that** at least one further functional module is the safe computer (9).

## Revendications

1. Dispositif (1) pour mesurer ou détecter d'une manière fiable un courant électrique d'un dispositif (2a, 11) de sécurité, notamment d'une lampe (2a) de signalisation, d'une aiguille à moteur électrique, d'un compteur d'essieu, d'un dispositif indicateur de voie libre ou analogue, ainsi qu'un dispositif d'interrogation de contact fiable,
comprenant une bobine (3) primaire parcourue par du courant pour la production d'un champ (Hp) magnétique qui est transformé par un capteur (5) séparé galvaniquement de la bobine (2) primaire en un signal (Us) de capteur, qui dépend du champ magnétique et
comprenant une bobine (6) de contrôle, par laquelle il est envoyé, de façon commandé par un ordinateur (9), un courant prescrit en valeur de courant et en sens du courant, le champ (Ht) magnétique de contrôle produit par le courant modifiant le signal (Us) de capteur et le fonctionnement du dispositif (1) étant contrôlé au moyen de la variation du signal (Us) de capteur,
**caractérisé**
**en ce que** l'ordinateur (9) a, de façon sûre du point de vue de la sécurité, deux canaux (7, 8) indépendants l'un de l'autre,
**en ce que** le courant est envoyé dans la bobine (6) de contrôle sous la forme d'une impulsion (10) de courant par l'un des deux canaux (7 et 8) et
**en ce que** le fonctionnement du dispositif (1) est contrôlé au moyen de la variation par l'autre canal (8 et 7).

2. Dispositif (1) suivant la revendication 1,
**caractérisé**
**en ce que** le capteur (5) est enfilé dans les deux bobines (3, 6) cylindriques disposées l'une derrière l'autre.

3. Dispositif (1) suivant la revendication 1 ou 2,
**caractérisé**
**en ce que** le capteur (5) a un capteur Hall.

4. Dispositif (1) suivant l'une des revendication 1 à 3,
**caractérisé**
**en ce que** le dispositif (1) peut être utilisé pour contrôler une demande de contact sans potentiel dans l'utilisation « détection d'un courant électrique d'un dispositif de sécurité », un limiteur (12) de courant étant monté en amont de la bobine (3) primaire.

5. Dispositif (1) suivant l'une des revendications 1 à 4,
**caractérisé**
**en ce que** l'unité (1) est constituée en module,
**en ce que** le module fait partie d'un groupe de modules de fonction pouvant être combinés entre eux, dont les fonctionnalités sont communes à des circuits de processus différents pour la sécurité du fonctionnement de dispositif (2a, 11) de sécurité et en ce qu'au moins un autre module de fonction est l'ordinateur (9) fiable.
